# EUROPÄISCHE PATENTSCHRIFT

(11) **EP 2 747 127 B1**
(45) Veröffentlichungstag und Bekanntmachung des Hinweises auf die Patenterteilung: **20.11.2019**
(21) Anmeldenummer: 13198088.0
(22) Anmeldetag: 18.12.2013
(51) Int. Cl.: H01L 21/20

(54) **Template für laterales Überwachsen mindestens einer Gruppe-III-Nitrid-basierten Schicht**
Templates for the lateral overgrowth of at least one group III nitride based layer
Schéma de surcroissance latérale d'au moins une couche à base de nitrure du groupe III

(30) Priorität: 20.12.2012 DE 102012223986
(43) Veröffentlichungstag der Anmeldung: 25.06.2014
(73) Patentinhaber: Forschungsverbund Berlin e.V., 12489 Berlin (DE)
(72) Erfinder: Weyers, Markus, 15745 Wildau (DE); Kneissl, Michael, 10435 Berlin (DE); Küller, Viola, 12053 Berlin (DE); Einfeldt, Sven, 12621 Berlin (DE); Knauer, Arne, 15754 Heidesee (DE)
(74) Vertreter: Gulde & Partner

(56) Entgegenhaltungen:
- EP-A2- 1 731 632
- WO-A1-2010/072273
- US-A1- 2005 145 865

## Beschreibung

### Stand der Technik

Laterales Überwachsen oder Pendeo-Epitaxie ist ein Verfahren, um durch das Lateralwachstum einer Gruppe-III-Nitrid-Schicht auf strukturierten Templates, also beispielsweise Saphir-, Silizium- oder SiC-basierten Substraten, mit einer Gruppe-III-Nitrid-basierten Schicht, eine Versetzungsdichtereduktion und damit hohe Quantenausbeute und effiziente Bauelemente zu erreichen. Solche Verfahren finden zum Beispiel in der Herstellung von im Ultraviolettbereich Licht emittierenden Dioden (UV-LED) Anwendung.

Eine übliche Form der Strukturierung dieser Templates ist ein Streifenmuster von durch parallele Stege getrennten parallelen Vertiefungen. Ein solches Template wird beispielsweise im US Patent 7,632,742 B2 beschrieben, wobei die parallelen Stege eine Unterbrechung aufweisen und an einer Seite der Unterbrechung durch eine Lösungsbarriereschicht verbunden sind. Ein Template, welches gestaltet wurde, um Spannung zu reduzieren, wird im US patent 7,951,693 B1 beschrieben. Weitere herkömmliche Templates werden in WO 2010/072273 A1, US 2005/145865 A1 und EP 1 731 632 A2 offenbart.

### Offenbarung der Erfindung

Es wurde beobachtet, dass es infolge von Verspannungen und/oder mechanischen Einwirkungen zur Ablösung der aufgewachsenen Schicht von der strukturierten Unterlage (dem Template) kommen kann, insbesondere nach einem Aufwachsen von einer Aluminiumnitrid-Schicht (AIN-Schicht).

Zudem wurde herausgefunden, dass sich die Schichtablösungsproblematik verringert, wenn die strukturierte Aufwachsschicht Verbindungsstege aufweist.

Daher wird erfindungsgemäß ein Template nach Anspruch 1 vorgeschlagen, welches für laterales Überwachsen mindestens einer Gruppe-III-Nitrid-basierten Schicht entlang einer ersten Richtung geeignet ist. Das Template umfasst zumindest in einem Teilbereich, welcher durch Vertiefungen strukturiert ist. Die Vertiefungen erstrecken sich in die erste Richtung und sind durch annähernd parallele Stege getrennt, die sich hauptsächlich in der ersten Richtung erstrecken und in einer zu der ersten Richtung senkrechten zweiten Richtung hintereinander angeordnet sind.

Das Template ist so ausgebildet, dass der strukturierte Teilbereich Verbindungsstege aufweist, die die benachbarten Stege jeweils paarweise so miteinander verbinden, dass die Vertiefungen vollständig durch Stege eingeschlossen ist. Dies hat den Vorteil, dass auch bei starker Verspannung und/oder mechanischer Belastung keine Schichtablösung auftritt.

Das Template ist dadurch gekennzeichnet, dass das Template ein Saphir-basiertes Substrat mit einer Fehlorientierung des Saphirs in a-Richtung von 0,1 - 0,25 Grad und einer Fehlorientierung des Saphirs in m-Richtung von 0,1 - 0,5 Grad ist.

Die erfindungsgemäßen Verbindungsstege verhindern zudem das Ein- und Vordringen von Gasen oder Flüssigkeiten, zum Beispiel von Sauerstoff oder Ätzflüssigkeiten, in die nach Aufwachsen einer Gruppe-III-Nitrid-basierten Schicht durch die Gräben und die aufgewachsene Schicht gebildeten Hohlräume. Damit soll die Stabilität gegenüber Einwirkung fremder Medien verbessert und ein Ablösen der Schichten vom Template verhindert werden.

In einer Ausführungsform bilden die Verbindungsstege mit der zweiten Richtung einen Winkel von mindestens 20 Grad und höchstens 40 Grad, wobei ein Winkel von im Wesentlichen 30 Grad bevorzugt ist. Dabei beziehen sich alle Winkelangaben auf einen Vollkreis von 360 Grad.

Durch die Winkelwahl werden während des epitaktischen Aufwachsens äquivalente Kristallfacetten angeboten, die zu einem noch weiter verbesserten Aufwachsen führen können.

In einer Ausführungsform kann einer der parallelen Stege mit mindestens einem benachbarten parallelen Steg mindestens durch zwei zueinander benachbarte Verbindungsstege verbunden sein, die bezüglich der zweiten Richtung zu einander spiegelsymmetrisch sind, wobei der benachbarte parallele Steg bezüglich der ersten Richtung auf einer Seite neben dem einen der parallelen Stege angeordnet ist.

Dann kann der eine der parallelen Stege mindestens durch zwei andere zueinander benachbarte Verbindungsstege mit einem anderen benachbarten parallelen Steg verbunden sein. Dabei sind die zwei anderen zueinander benachbarten Verbindungsstege bezüglich der ersten Richtung spiegelsymmetrisch zu den zwei zueinander benachbarten Verbindungsstegen ausgebildet und angeordnet, wobei der andere benachbarte parallele Steg bezüglich der ersten Richtung auf der anderen Seite neben dem einen der parallelen Stege angeordnet ist.

Zusätzlich oder alternativ können dann auch die zwei zueinander benachbarten Verbindungsstege an Endpunkten des einen der parallelen Stege angeordnet sein und je mit dem einen der parallelen Stege einen Winkel von im Wesentlichen 120 Grad einschließen.

Sind die zwei zueinander benachbarten Verbindungsstege an Endpunkten des einen der parallelen Stege angeordnet, so können die zwei zueinander benachbarten Verbindungsstege je einen ersten und einen zweiten Teilsteg umfassen, wobei jeweils der erste mit dem zweiten Teilsteg einen Winkel von im Wesentlichen 120 Grad einschließt.

Dann können die ersten Teilstege den einen der parallelen Stege mit zwei, bezüglich der ersten Richtung versetzten, parallelen Stegen verbinden und die zweiten Teilstege die zwei, bezüglich der ersten Richtung versetzten, parallelen Stege mit dem benachbarten parallelen Steg verbinden. Dabei ist einer der bezüglich der ersten Richtung versetzten parallelen Stege bezüglich der ersten Richtung hinter dem einen der parallelen Stege und der andere der bezüglich der ersten Richtung versetzten parallelen Stege bezüglich der ersten Richtung vor dem einen der parallelen Steg angeordnet. Die zwei, bezüglich der ersten Richtung versetzten, parallelen Stege sind dabei bezüglich der ersten Richtung hintereinander angeordnet.

In einer anderen Ausführungsform kann einer der parallelen Stege mit mindestens einem auf einer Seite benachbarten parallelen Steg mindestens durch zwei zueinander benachbarte und zueinander parallele Verbindungsstege verbunden sein.

Dann kann der eine der parallelen Stege mindestens durch zwei andere zueinander benachbarte Verbindungsstege mit einem anderen benachbarten parallelen Stege verbunden sein, die, bezüglich der ersten Richtung und zu den zwei zueinander benachbarten Verbindungsstegen, spiegelsymmetrisch ausgebildet und versetzt angeordnet sind. Dann ist der andere benachbarte parallele Steg bezüglich der ersten Richtung auf der anderen Seite des einen der parallelen Stege angeordnet.

Die Vertiefungen können in der zweiten Richtung eine im Wesentlichen konstante Vertiefungsbreite und in der ersten Richtung eine im Wesentlichen konstante Vertiefungslänge haben, die mindestens dem Fünffachen und höchstens dem Fünfzigfachen der Vertiefungsbreite entspricht.

Die Vertiefungen können geätzt sein. Die Vertiefungen sind in einer auf ein Substrat aufgewachsenen Aufwachsschicht gebildet und haben eine Vertiefungstiefe die geringer als eine Schichtdicke der Aufwachsschicht ist. Letzteres erhöht die Haftung zusätzlich und wirkt so auch einer Ablösung entgegen. Die Aufwachsschicht ist auf einem Saphir-basierten Substrat gebildet, und die Vertiefungstiefe geringer als die Schichtdicke ermöglicht zudem eine Fehlorientierung des Saphirs in a-Richtung, mit deren Hilfe sehr glatte Oberflächen erzielt werden können. Die Fehlorientierung in a-Richtung beträgt zwischen 0,1 und 0,5 Grad, bevorzugt 0,25 Grad.

Bei einem Saphir-basierten Substrat kann eine Fehlorientierung des Saphirs in m-Richtung eine sehr homogene Koaleszenz bewirken. Die Fehlorientierung in m-Richtung beträgt zwischen 0,1 und 0,5 Grad, bevorzugt 0,25 Grad.

Weitere vorteilhafte Ausführungsformen sind in den Beispielen beschrieben.

### Zeichnungen

Ausführungsbeispiele der Erfindung werden anhand der Zeichnungen und der nachfolgenden Beschreibung näher erläutert. Es zeigen:
- Figur 1: eine beispielhafte erste Ausführungsform der Erfindung,
- Figur 2: eine beispielhafte zweite Ausführungsform der Erfindung und
- Figur 3: eine beispielhafte dritte Ausführungsform der Erfindung.

### Ausführungsformen der Erfindung

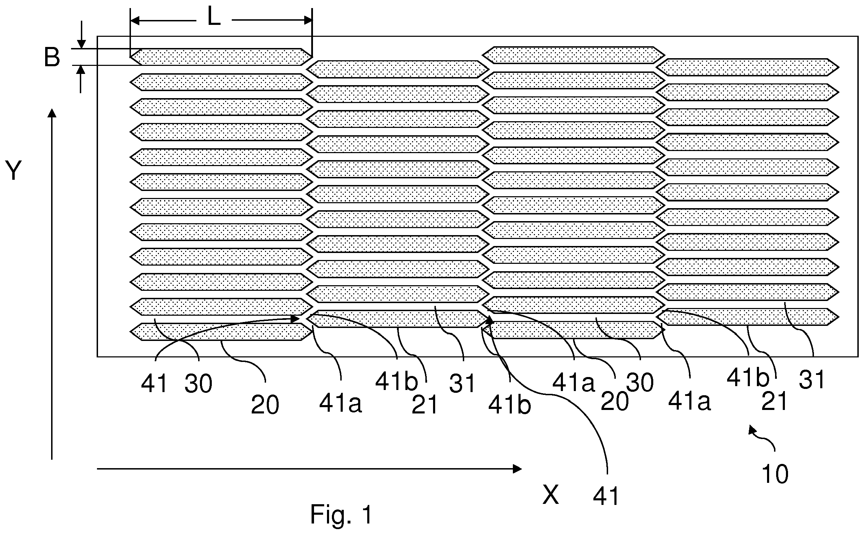

Figur 1 zeigt eine erste beispielhafte Ausführungsform der Erfindung. Figur 1 zeigt ein Template 10 in Aufsicht. Das Template 10 weist wabenförmige, im Folgenden auch als Gräben bezeichnete Vertiefungen 20, 21 auf, die durch parallele Stege 30, 31 von einander getrennt sind. In Figur 1 sind die Waben 20, 21 dabei im Wesentlichen von gleicher Form und Größe und langgezogen, das heißt, sie weisen je zwei parallele, längere Seitenwände, die durch die Stege 30, 31 gebildet werden und im Wesentlichen alle eine erste Länge haben, und je vier kürzere Seitenwände auf, wobei die kürzeren Seitenwände alle im Wesentlichen eine kürzere zweite Länge haben und durch Verbindungsteilstege 41a, 41b gebildet werden. Die Stege 30, 31 erstrecken sich in eine erste Richtung X. Das Template kann zum Beispiel aus Saphir (Al₂O₃), Siliziumkarbid (SiC) oder Silizium bestehen oder Saphir (Al₂O₃), Siliziumkarbid (SiC) oder Silizium als Substrat umfassen. Die Vertiefungen sind dabei entweder im Substrat selbst realisiert oder in einer auf dem Substrat aufgebrachten Aufwachsschicht, die beispielsweise eine Gruppe III-Nitrid-basierte Schicht ist.

Reihen von zueinander in der ersten Richtung X um jeweils eine Wabenlänge L beabstandete Stege 30 wechseln sich in einer zweiten, zu der ersten Richtung senkrechten Richtung Y mit solchen Reihen von Stegen 31 ab, wobei die Stege 31 zu den Stegen 30 jeweils in der ersten Richtung X um die Wabenlänge L und in der zweiten Richtung Y um eine halbe Wabenbreite B versetzt sind.

Endpunkte der Stege 30 sind durch die Verbindungsteilstege 41a, 41b mit Endpunkten der zum jeweiligen Steg 30 um die Wabenlänge L versetzten Stege 31 benachbarter Reihen verbunden. Bezüglich der Richtung Y weisen die Verbindungsteilstege 41a, 41b einen Winkel von im Wesentlichen 30 Grad auf, wobei je nach Produktionsgenauigkeit auch Winkel zwischen 25 und 35 Grad toleriert werden.

Aus den Verbindungsteilstegen 41a, 41b gebildete Verbindungsstege 41 die zwei Stege 30 benachbarter Reihen miteinander verbinden, sind bezüglich der ersten Richtung spiegelsymmetrisch zueinander. Genauso sind die Verbindungsstege 41, die aus den Verbindungsteilstegen 41a, 41b gebildet sind und zwei Stege 31 benachbarter Reihen miteinander verbinden, bezüglich der ersten Richtung spiegelsymmetrisch zueinander.

Die Verbindungsteilstege 41a, 41b schließen untereinander und mit den Stegen 30, 31, deren Endpunkte sie verbinden, jeweils einen Winkel von im Wesentlichen 120 Grad ein, wobei je nach Produktionsgenauigkeit auch Winkel zwischen 115 und 125 Grad toleriert werden.

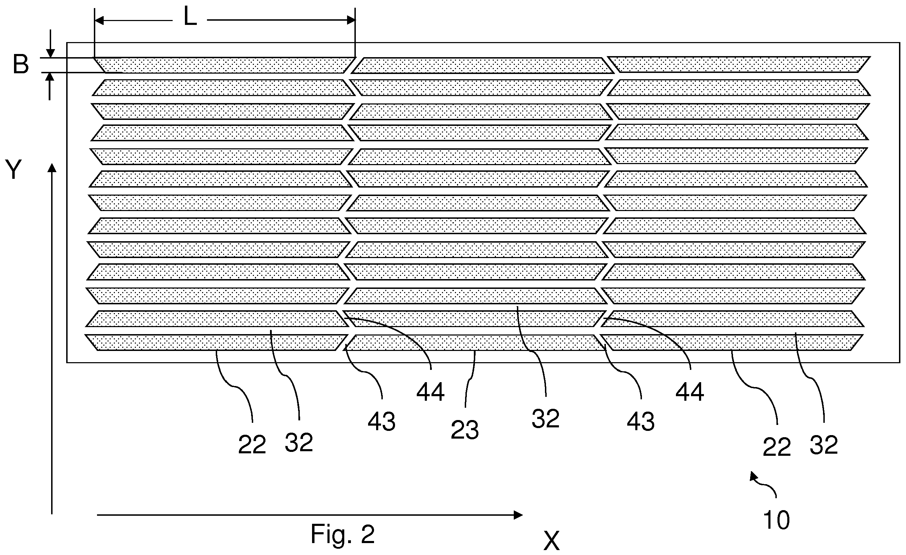

Figur 2 zeigt eine zweite beispielhafte Ausführungsform der Erfindung. Figur 2 zeigt wieder ein Template 10 in Aufsicht. Das Template 10 weist trapezförmige Vertiefungen 22, 23 auf, die durch parallele Stege 32 von einander getrennt sind. Die benachbarten parallelen Stege 32 haben dabei zueinander einen im Wesentlichen gleichen Abstand B. Die trapezförmigen Vertiefungen 22, 23 weisen je zwei parallele, längere Seitenwände, die durch die Stege 32 gebildet werden, und je zwei kürzere Seitenwände auf, wobei die kürzeren Seitenwände alle im Wesentlichen eine gleiche Länge haben und durch Verbindungsstege 43, 44 gebildet werden. Die Stege 32 erstrecken sich in eine erste Richtung X.

Die Stege 32 sind bezüglich der ersten Richtung X nebeneinander angeordnet. Jeder der Stege 32 ist in regelmäßigen Abständen durch die Verbindungsstege 43, 44 mit benachbarten parallelen Stegen 32 verbunden.

Dabei ist der Verbindungssteg 43, der einen gegebenen Steg 32 mit dessen Nachbarsteg 32 auf einer Seite verbindet, bezüglich der Richtung X auf einer selben Höhe angeordnet wie der Verbindungssteg 44, der den gegebenen Steg 32 mit dessen Nachbarsteg 32 auf der anderen Seite verbindet. Dabei ist der Abstand zwischen zueinander benachbarten Verbindungsstegen 43 im Wesentlichen konstant. Ebenso ist der Abstand zwischen zueinander benachbarten Verbindungsstegen 44 im Wesentlichen konstant.

Die Verbindungsstege 43, 44 bewirken, dass die Aufwachsschicht durch in Aufwachsrichtung X hintereinander angeordnete trapezförmige Vertiefungen 22, 23 strukturiert ist. Dabei erstreckt sich die jeweilige Basis L der trapezförmigen Vertiefungen 22, 23 in die erste Richtung X und die jeweilige Höhe B der trapezförmigen Vertiefungen 22, 23 erstreckt sich in der zweiten Richtung Y. Das Verhältnis von Basis zu Höhe kann zum Beispiel mindestens fünf-zu-eins und höchstens fünfzig-zu-eins betragen. Die Ausrichtung der Trapeze 22, 23 alterniert dabei in der ersten Richtung X. Ebenso alterniert die Ausrichtung der Trapeze 22, 23 in der zweiten Richtung Y.

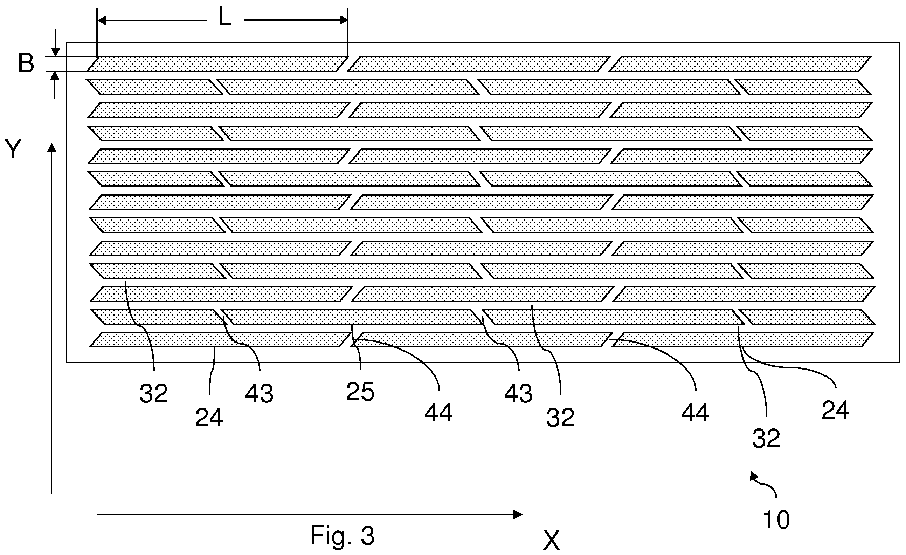

Figur 3 zeigt eine dritte beispielhafte Ausführungsform der Erfindung. Figur 3 zeigt wieder ein Template 10 in Aufsicht. Das Template 10 weist parallelogrammförmige Vertiefungen 24, 25 auf, die durch parallele Stege 32 von einander getrennt sind. Die parallelogrammförmigen Vertiefungen 24, 25 weisen je zwei parallele, längere Seitenwände, die durch die Stege 32 gebildet werden, und je zwei kürzere parallele Seitenwände auf, wobei die kürzeren parallelen Seitenwände alle im Wesentlichen eine gleiche Länge haben und durch Verbindungsstege 43, 44 gebildet werden. Die Stege 32 erstrecken sich in eine erste Richtung X.

Die Stege 32 sind bezüglich der ersten Richtung X nebeneinander angeordnet. Jeder der Stege 32 ist in regelmäßigen Abständen durch die Verbindungsstege 43, 44 mit benachbarten parallelen Stegen 32 verbunden.

Dabei ist der Verbindungssteg 43, der einen gegebenen Steg 32 mit dessen Nachbarsteg 32 auf einer Seite verbindet, bezüglich der Richtung X auf halber Strecke zwischen zwei Verbindungsstegen 44 angeordnet, die den gegebenen Steg 32 mit dessen Nachbarsteg 32 auf der anderen Seite verbinden.

Die Verbindungsstege 43, 44 bewirken, dass die Aufwachsschicht durch in Aufwachsrichtung X hintereinander angeordnete parallelogrammförmige Vertiefungen 24, 25 strukturiert ist, die ein längeres Seitenwandpaar und ein kürzeres Seitenwandpaar aufweisen. Dabei erstreckt sich das längere Seitenwandpaar in die erste Richtung X. Das Verhältnis von der Länge L des längeren Seitenwandpaars zur Höhe B kann zum Beispiel mindestens fünf-zu-eins und höchstens fünfzig-zu-eins betragen. In der ersten Richtung X hintereinander angeordnete Parallelogramme 24, 25 sind dabei identisch. Zwei zueinander benachbarte Reihen von in der ersten Richtung X hintereinander angeordneten Parallelogrammen 24, 25 sind zueinander spiegelsymmetrisch und um eine halbe Länge L/2 der längeren Seitenwände der Parallelogramme zueinander versetzt.

In einem weiteren Ausführungsbeispiel wird ein Template vorgestellt für heteroepitaktisches Aufwachsen mindestens einer Gruppe III-Nitrid-basierten Schicht entlang einer ersten Richtung. Das beispielhafte Template umfasst eine strukturierte Aufwachsschicht, die beispielsweise eine Gruppe III-Nitrid-basierte Schicht ist und zumindest in einem Teilbereich durch parallele, längliche Vertiefungen mit je mindestens vier Seitenwänden strukturiert ist. Mindestens zwei der Seitenwände sind zueinander parallel. In zumindest zwei Ecken jeder Vertiefung schließen die Seitenwände der Vertiefung einen Winkel von im Wesentlichen 120 Grad ein.

Beispielhaft weisen die Vertiefungen genau vier Seitenwände auf, die in zwei weiteren Ecken jeder Vertiefung einen anderen Winkel einschließen, wobei der eine Winkel und der andere Winkel sich zu 180 Grad ergänzen.

Es ist möglich, dass die zwei Ecken zueinander benachbart sind und die zwei weiteren Ecken ebenfalls zueinander benachbart sind. Es ist aber auch möglich, dass jede der zwei Ecken zu den zwei weiteren Ecken benachbart ist.

In einem anderen Beispiel weisen die Vertiefungen genau sechs Seitenwände auf, die jeweils paarweise einen Winkel von im Wesentlichen 120 Grad einschließen.

Gemeinhin können die Vertiefungen zwei längere Seitenwände aufweisen, wobei die längeren Seitenwände einer Vertiefung zueinander und zu den längeren Seitenwänden der anderen Vertiefungen parallel sind.

Die Vertiefungen können auch mindestens zwei kürzere Seitenwände aufweisen, wobei die kürzeren Seitenwände einer Vertiefung zueinander und zu den kürzeren Seitenwänden der anderen Vertiefungen parallel sind.

In einer beispielhaften Ausführungsform mit Waben, Trapezen oder Parallelogrammen haben alle Stege eine im Wesentlichen gleiche Stegbreite von 1-50 µm, wobei eine gleiche Stegbreite von 1-3 µm bevorzugt wird. Insbesondere kann die Stegbreite 2,5 µm betragen.

In der ersten Richtung X beträgt dann der Abstand zwischen zwei benachbarten Verbindungsstegen 1-10.000 µm, wobei ein Verbindungsstegabstand von 20-500 µm bevorzugt ist. Insbesondere kann der Abstand 30 µm betragen. Bei Waben oder Trapezen kann der Abstand auch 3 µm oder 300 µm betragen.

In der zweiten Richtung Y beträgt der Abstand B zwischen zwei benachbarten parallelen Stegen 1-100 µm, wobei ein Abstand B von 1-10 µm bevorzugt ist. Insbesondere kann der Abstand 1 µm betragen.

## Patentansprüche

1. Template (10) für laterales Überwachsen mindestens einer Gruppe III-Nitrid-basierten Schicht entlang einer ersten Richtung (X), wobei das Template (10) zumindest in einem Teilbereich durch Vertiefungen (20, 21, 22, 23, 24, 25) strukturiert ist, die sich in die erste Richtung erstrecken und durch parallele Stege (30, 31, 32) getrennt sind, die sich in der ersten Richtung (X) erstrecken und in einer zu der ersten Richtung (X) senkrechten zweiten Richtung (Y) hintereinander angeordnet sind, wobei der strukturierte Teilbereich Verbindungsstege (41, 43, 44) aufweist, die die parallelen Stege (30, 31, 32) so miteinander verbinden, dass die Vertiefungen vollständig durch Stege eingeschlossen sind,
wobei die Vertiefungen (20, 21, 22, 23, 24, 25) in einer auf ein Substrat aufgewachsenen Aufwachsschicht gebildet sind und eine Vertiefungstiefe haben, die geringer als eine Schichtdicke der Aufwachsschicht ist, **dadurch gekennzeichnet, dass** das Template ein Saphir-basiertes Substrat mit einer Fehlorientierung des Saphirs in a-Richtung von 0,1 - 0,25 Grad und einer Fehlorientierung des Saphirs in m-Richtung von 0,1 - 0,5 Grad ist.

2. Template nach Anspruch 1, wobei die Verbindungsstege (41, 43, 44) mit der zweiten Richtung (Y) einen Winkel von mindestens 20 und höchstens 40 Grad bilden.

3. Template nach Anspruch 1 oder 2, wobei einer der parallelen Stege (30, 31, 32) mit mindestens einem benachbarten parallelen Steg (30, 31, 32) mindestens durch zwei zueinander benachbarte Verbindungsstege (41, 43, 44) verbunden ist, die bezüglich der zweiten Richtung zu einander spiegelsymmetrisch sind, wobei der benachbarte parallele Steg (30, 31, 32) bezüglich der ersten Richtung (X) auf einer Seite neben dem einen der parallelen Stege (30, 31, 32) angeordnet ist.

4. Template nach Anspruch 3, wobei der eine der parallelen Stege (30, 31, 32) mindestens durch zwei andere zueinander benachbarte Verbindungsstege (41, 43, 44) mit einem anderen benachbarten parallelen Steg (30, 31, 32) verbunden ist, wobei die zwei anderen zueinander benachbarten Verbindungsstege (41, 43, 44) bezüglich der ersten Richtung (X) spiegelsymmetrisch zu den zwei zueinander benachbarten Verbindungsstegen (41, 43, 44) ausgebildet und angeordnet sind, wobei der andere benachbarte parallele Steg (30, 31, 32) bezüglich der ersten Richtung (X) auf der anderen Seite neben dem einen der parallelen Stege (30, 31, 32) angeordnet ist.

5. Template nach Anspruch 3 oder 4, wobei die zwei zueinander benachbarten Verbindungsstege (41) an Endpunkten des einen der parallelen Stege (30, 31) angeordnet sind und je mit dem einen der parallelen Stege (30, 31) einen Winkel von 120 Grad einschließen.

6. Template nach Anspruch 5, wobei die zwei zueinander benachbarten Verbindungsstege je einen ersten (41a) und einen zweiten Teilsteg (41b) umfassen, wobei jeweils der erste (41a) mit dem zweiten Teilsteg (41b) einen Winkel von 120 Grad einschließt.

7. Template nach Anspruch 6, wobei die ersten Teilstege (41a) den einen der parallelen Stege (30, 31) mit zwei, bezüglich der ersten Richtung (X) versetzten, parallelen Stegen (31, 30) verbinden, die zweiten Teilstege (41b) die zwei, bezüglich der ersten Richtung (X) versetzten, parallelen Stege (31, 30) mit dem benachbarten parallelen Steg (30, 31) verbinden und wobei einer der bezüglich der ersten Richtung (X) versetzten parallelen Stege (31, 30) bezüglich der ersten Richtung (X) hinter dem einen der parallelen Stege (30, 31) und der andere der bezüglich der ersten Richtung (X) versetzten parallelen Stege (31, 30) bezüglich der ersten Richtung (X) vor dem einen der parallelen Stege (30, 31) angeordnet ist und wobei die zwei, bezüglich der ersten Richtung (X) versetzten, parallelen Stege (31, 30) bezüglich der ersten Richtung (X) hintereinander angeordnet sind.

8. Template nach Anspruch 1, wobei einer der parallelen Stege (32) mit mindestens einem benachbarten parallelen Steg (32) mindestens durch zwei zueinander benachbarte und zueinander parallele Verbindungsstege (43, 44) miteinander verbunden ist.

9. Template nach Anspruch 8, wobei der eine der parallelen Stege (32) mindestens durch zwei andere zueinander benachbarte Verbindungsstege (43, 44) mit einem anderen benachbarten parallelen Steg (32) verbunden ist, die, bezüglich der ersten Richtung (X) und zu den zwei zueinander benachbarten Verbindungsstegen (43, 44), spiegelsymmetrisch ausgebildet und versetzt angeordnet sind, wobei der andere benachbarte parallele Steg (32) bezüglich der ersten Richtung (X) neben dem einen der parallelen Stege (32) angeordnet ist.

10. Template nach einem der vorangehenden Ansprüche, wobei die Vertiefungen (20, 21, 22, 23, 24, 25) in der zweiten Richtung (Y) alle eine gleiche Vertiefungsbreite (B) und in der ersten Richtung (X) eine gleiche Vertiefungslänge (L) haben, die mindestens dem Fünffachen und höchstens dem Fünfzigfachen der Vertiefungsbreite (B) entspricht.

## Claims

1. A template (10) for the lateral overgrowth of at least one group III nitride-based layer along a first direction (X), wherein the template (10) is patterned at least in one sub-region by wells (20, 21, 22, 23, 24, 25) which extend in the first direction and are separated by parallel ribs (30, 31, 32) which extend in the first direction (X) and are arranged one behind another in a second direction (Y) perpendicular to the first direction (X), wherein the patterned sub-region has connecting ribs (41, 43, 44) which connect the parallel ribs (30, 31, 32) together in such a way that the wells are completely enclosed by ribs, wherein the wells (20, 21, 22, 23, 24, 25) are formed in a growth layer grown on a substrate and having a well depth which is less than a layer thickness of the growth layer, **characterized in that** the template is a sapphire-based substrate with an a-plane misorientation of the sapphire of 0.1-0.25 degrees and an m-plane misorientation of the sapphire of 0.1-0.5 degrees.

2. The template according to Claim 1, wherein the connecting ribs (41, 43, 44) form an angle of at least 20 and at most 40 degrees with the second direction (Y).

3. The template according to Claim 1 or Claim 2, wherein one of the parallel ribs (30, 31, 32) is connected to at least one adjacent parallel rib (30, 31, 32) at least by two mutually adjacent connecting ribs (41, 43, 44) which are mirror-symmetrical to one another with regard to the second direction, wherein, with regard to the first direction (X), the adjacent parallel rib (30, 31, 32) is arranged to one side next to the one of the parallel ribs (30, 31, 32).

4. The template according to Claim 3, wherein the one of the parallel ribs (30, 31, 32) is connected by at least two other mutually adjacent connecting ribs (41, 43, 44) to another adjacent parallel rib (30, 31, 32), wherein, with regard to the first direction (X), the two other mutually adjacent connecting ribs (41, 43, 44) are configured and arranged mirror-symmetrically to the two mutually adjacent connecting ribs (41, 43, 44), wherein, with regard to the first direction (X), the other adjacent parallel rib (30, 31, 32) is arranged to the other side next to the one of the parallel ribs (30, 31, 32).

5. The template according to Claim 3 or Claim 4, wherein the two mutually adjacent connecting ribs (41) are arranged at end points of the one of the parallel ribs (30, 31) and each form an angle of 120 degrees with the one of the parallel ribs (30, 31).

6. The template according to Claim 5, wherein the two mutually adjacent connecting ribs each comprise a first (41a) and a second (41b) sub-rib, wherein in each case the first sub-rib (41a) forms an angle of 120 degrees with the second sub-rib (41b).

7. The template according to Claim 6, wherein the first sub-ribs (41a) connect the one of the parallel ribs (30, 31) to two parallel ribs (31, 30) which are offset with regard to the first direction (X), the second sub-ribs (41b) connect the two parallel ribs (31, 30) which are offset with regard to the first direction (X) to the adjacent parallel rib (30, 31) and wherein one of the parallel ribs (31, 30), which are offset with regard to the first direction (X), is arranged behind the one of the parallel ribs (30, 31) and the other of the ribs (31, 30), which are offset with regard to the first direction (X), is arranged in front of the one of the parallel ribs (30, 31) and wherein the two parallel ribs (31, 30), which are offset with regard to the first direction (X), are arranged one behind another with regard to the first direction (X).

8. The template according to Claim 1, wherein one of the parallel ribs (32) is connected together with at least one adjacent parallel rib (32) at least by two mutually adjacent and mutually parallel connecting ribs (43, 44).

9. The template according to Claim 8, wherein the one of the parallel ribs (32) is connected at least by two other mutually adjacent connecting ribs (43, 44) to another adjacent parallel rib (32) which, with regard to the first direction (X) and to the two mutually adjacent connecting ribs (43, 44), are configured mirror-symmetrically and arranged with an offset, wherein the other adjacent parallel rib (32) is arranged, with regard to the first direction (X), next to the one of the parallel ribs (32).

10. The template according to one of the preceding claims, wherein, in the second direction (Y), the wells (20, 21, 22, 23, 24, 25) all have an identical well width (B) and, in the first direction (X), an identical well length (L) which amounts to at least five times and to at most fifty times the well width (B).

## Revendications

1. Matrice (10) pour la surcroissance latérale d'au moins une couche à base de nitrure du groupe III selon une première direction (X), où ladite matrice (10) est structurée au moins dans une zone partielle par des évidements (20, 21, 22, 23, 24, 25) s'étendant dans la première direction et séparés par des nervures parallèles (30, 31, 32) s'étendant dans la première direction (X) et disposées les unes derrière les autres dans une deuxième direction (Y) perpendiculaire à la première direction (X), où la zone partielle structurée présente des nervures de liaison (41, 43, 44) reliant entre elles les nervures parallèles (30, 31, 32) de telle manière que les évidements sont totalement inclus dans les nervures, où les évidements (20, 21, 22, 23, 24, 25) sont formés sur une couche de croissance présentée sur un substrat et ont une profondeur inférieure à l'épaisseur de la couche de croissance, **caractérisée en ce que** ladite matrice est un substrat à base de saphir avec un défaut d'orientation du saphir dans la direction a compris entre 0,1 et 0,25° et un défaut d'orientation du saphir dans la direction m compris entre 0,1 et 0,5°.

2. Matrice selon la revendication 1, où les nervures de liaison (41, 43, 44) dans la deuxième direction (Y) forment un angle compris entre 20° et 40°.

3. Matrice selon la revendication 1 ou la revendication 2, où une des nervures parallèles (30, 31, 32) est reliée à au moins une nervure parallèle (30, 31, 32) contiguë au moins par deux nervures de liaison (41, 43, 44) contiguës, symétriques l'une à l'autre par rapport à la deuxième direction, où la nervure parallèle (30, 31, 32) contiguë est juxtaposée à la première des nervures parallèles (30, 31, 32) sur un côté par rapport à la première direction (X).

4. Matrice selon la revendication 3, où la première des nervures parallèles (30, 31, 32) est reliée au moins par deux autres nervures de liaison (41, 43, 44) contiguës l'une à l'autre à une autre nervure parallèle (30, 31, 32) contiguë, où les deux autres nervures de liaison (41, 43, 44) contiguës l'une à l'autre sont formées et disposées symétriquement aux deux nervures de liaison (41, 43, 44) contiguës l'une à l'autre par rapport à la première direction (X), où l'autre nervure parallèle (30, 31, 32) contiguë est juxtaposée à la première des nervures parallèles (30, 31, 32) sur l'autre côté par rapport à la première direction (X).

5. Matrice selon la revendication 3 ou la revendication 4, où les deux nervures de liaison (41) contiguës l'une à l'autre sont disposées aux points d'extrémité de la première des nervures parallèles (30, 31) et forment chacune un angle de 120° avec la première des nervures parallèles (30, 31).

6. Matrice selon la revendication 5, où les deux nervures de liaison contiguës l'une à l'autre comprennent chacune une première (41a) et une deuxième nervure partielle (41b), chaque première (41a) nervure partielle (41b) formant un angle de 120° avec chaque deuxième nervure partielle.

7. Matrice selon la revendication 6, où les premières nervures partielles (41a) relient la première des nervures parallèles (30, 31) à deux nervures parallèles (31, 30) décalées par rapport à la première direction (X), les deuxièmes nervures partielles (41b) relient les deux nervures parallèles (31, 30) décalées par rapport à la première direction (X) à la nervure parallèle (30, 31) contiguë, et où une des nervures parallèles (31, 30) décalées par rapport à la première direction (X) est disposée derrière la première des nervures parallèles (30, 31) par rapport à la première direction (X) et l'autre des nervures parallèles (31, 30) décalées par rapport à la première direction (X) est disposée devant une des nervures parallèles (30, 31) par rapport à la première direction (X), et où les deux nervures parallèles (31, 30) décalées par rapport à la première direction (X) sont disposées l'une derrière l'autre par rapport à la première direction (X).

8. Matrice selon la revendication 1, où une des nervures parallèles (32) est reliée à au moins une nervure parallèle (32) contiguë au moins par deux nervures de liaison parallèles (43, 44) contiguës et parallèles l'une à l'autre.

9. Matrice selon la revendication 8, où la première des nervures parallèles (32) est reliée à une autre nervure parallèle (32) contiguë au moins par deux autres nervures de liaison (43, 44) contiguës l'une à l'autre, lesquelles sont symétriques et décalées entre elles par rapport à la première direction (X) et par rapport aux deux nervures de liaison (43, 44) contiguës l'une à l'autre, l'autre nervure parallèle (32) contiguë par rapport à la première direction (X) étant juxtaposée à la première des nervures parallèles (32).

10. Matrice selon l'une quelconque des revendications précédentes, où les évidements (20, 21, 22, 23, 24, 25) ont tous la même largeur (B) dans la deuxième direction (Y) et la même longueur (L) dans la première direction (X), laquelle correspond au minimum au quintuple et au maximum à cinquante fois la largeur d'évidement (B).
